# FASCICULE DE BREVET EUROPEEN

(11) **EP 0 881 681 B1**
(45) Date de publication et mention de la délivrance du brevet: **10.05.2006**
(21) Numéro de dépôt: 98410056.0
(22) Date de dépôt: 22.05.1998
(51) Int. Cl.: H01L 27/02

(54) **Composant de protection d'un transitor MOS intégré contre des gradients de tension**
Anordnung zum Schützen einer integrierten MOS-Vorrichtung gegen Spannungsabfälle
Device protecting an integrated MOS device against voltage gradients

(30) Priorité: 28.05.1997 FR 9706824
(43) Date de publication de la demande: 02.12.1998
(73) Titulaire: STMicroelectronics S.A., 92120 Montrouge (FR)
(72) Inventeur: Barret, Jean, 13510 Eguilles (FR); Pavlin, Antoine, 13540 Puyricard (FR); Fichera, Pietro, 13080 Luynes (FR)
(74) Mandataire: de Beaumont, Michel

(56) Documents cités:
- EP-A- 0 359 680
- PATENT ABSTRACTS OF JAPAN vol. 007, no. 027 (E-156), 3 février 1983 & JP 57 183064 A (TOKYO SHIBAURA DENKI KK), 11 novembre 1982

## Description

La présente invention concerne les composants associant dans un même substrat des transistors MOS de puissance verticaux de type diffusé (VDMOS) et des circuits logiques.

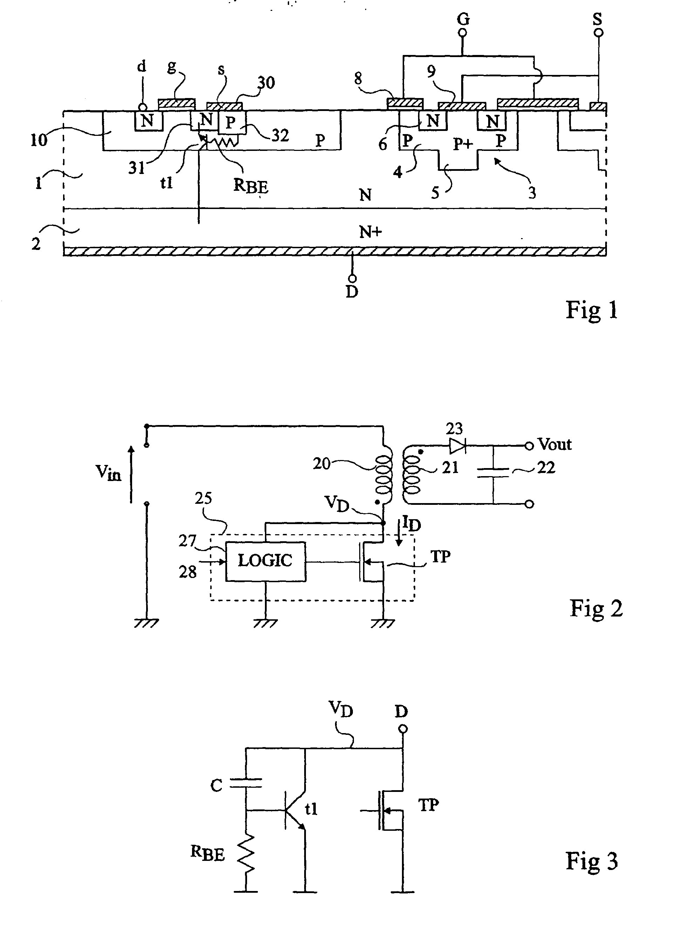

La figure 1 représente très schématiquement une portion d'un tel composant. Celui-ci comprend un substrat de type N généralement constitué d'une couche épitaxiée 1 de type N formée sur un substrat 2 de type N⁺. Dans la partie droite est formé un transistor de puissance et dans la partie gauche un caisson logique.

Le transistor de puissance comporte un ensemble de cellules identiques connectées les unes aux autres, telles que la cellule 3. Chaque cellule comprend un caisson 4 de type P dont la partie centrale 5 est plus fortement dopée. Dans la partie supérieure du caisson, est formé un anneau 6 de type N. La partie séparant la périphérie externe de l'anneau de type N de la périphérie externe du caisson de type P est revêtue d'une grille isolée 8 et l'anneau 6 de type N ainsi que la partie centrale 5 du caisson sont revêtus d'une métallisation 9. Toutes les grilles 8 sont connectées à une borne de grille G et toutes les métallisations 9 sont reliées à une borne de source S. La face arrière de la structure est revêtue d'une métallisation de drain D. Ainsi, quand un signal de grille est appliqué, un courant est susceptible de s'écouler de la borne D à la borne S depuis les régions N 1 et 2 vers les régions N 6, en passant par un canal formé sous les grilles isolées. Cette structure est généralement utilisée de sorte que le drain est polarisé à un potentiel positif par rapport à la source.

Bien que l'on ait mentionné ci-dessus des "cellules" identiques, le transistor de puissance peut avoir une structure digitée. Les régions 6 ne sont alors pas des "anneaux". On conservera néanmoins ce vocabulaire ci-après pour simplifier l'exposé.

Des circuits logiques sont formés dans un ou plusieurs caissons 10. On a représenté dans un caisson 10 un transistor MOS élémentaire ayant des bornes de drain, de source et de grille g, d et s. Ceci ne constitue qu'un exemple de composant susceptible d'être formé dans un caisson logique.

Dans certaines applications, par exemple dans des alimentations à découpage, un fort gradient de tension est susceptible d'apparaître entre le drain et la source du transistor MOS de puissance pendant une phase de commutation à l'ouverture.

La figure 2 représente un exemple de circuit d'alimentation à découpage. Une tension d'entrée Vᵢₙ est appliquée au primaire 20 d'un transformateur dont le secondaire 21 est relié à un condensateur 22 par l'intermédiaire d'une diode 23. Une tension de sortie Vₒᵤₜ est disponible aux bornes du condensateur 22. La deuxième borne du primaire 20 est reliée à la masse de l'alimentation par l'intermédiaire d'un composant intégré comprenant un transistor MOS de puissance vertical TP et un circuit logique 27. Ce circuit logique comprend notamment une borne reliée à la borne de drain du transistor de puissance, correspondant à la face arrière du composant de la figure 1, une borne reliée à la masse et au moins une borne d'entrée 28 recevant des signaux de commande. Ce circuit logique 27 est notamment destiné à commander la grille du transistor de puissance.

Le fonctionnement d'une alimentation à découpage est bien connu de l'homme de l'art. Il consiste à commuter périodiquement le transistor de puissance TP. A chaque commutation à l'ouverture du transistor de puissance TP, il se produit une montée en tension rapide et l'on souhaite effectivement qu'elle soit aussi rapide que possible. Même si aucun composant parasite n'intervient et que la tension aux bornes du transistor TP ne dépasse la tension maximale normale du circuit, on s'aperçoit que des composants intégrés du type de celui de la figure 1 sont dans certaines circonstances détériorés. Ce phénomène n'est a priori pas expliqué et c'est l'apport de la présente invention que d'avoir analysé ce phénomène, d'en avoir trouvé la cause et d'y avoir apporté un remède.

Ainsi, la présente invention prévoit un dispositif de protection contre des gradients de tension Selon la revendication 1. Un composant monolithique comprenant un transistor MOS de puissance vertical (VDMOS) et des circuits logiques, le substrat d'un premier type de conductivité du composant correspondant au drain du transistor MOS et les composants des circuits logiques étant réalisés dans au moins un caisson du deuxième type de conductivité formé dans la face supérieure du substrat et comprenant au moins une region du premier type de conductivité est connu de EP-A-0 359 680. Par ailleurs, une diode protégée par une résistance en série est décrite dans l'abregé correspondant à JP-A-57 183 064

Selon un mode de réalisation de la présente invention, la borne de chaque résistance non reliée à ladite région respective est reliée à un contact sur le caisson, connecté à la masse.

Selon un mode de réalisation de la présente invention, chaque résistance correspond à une région de silicium polycristallin formée sur une couche d'oxyde.

Selon un mode de réalisation de la présente invention, la couche d'oxyde est une couche d'oxyde épais.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe schématique et partielle d'un composant incluant un transistor MOS vertical et des circuits logiques ;
la figure 2 représente un exemple d'utilisation du composant de la figure 1 ;
la figure 3 représente un schéma équivalent d'éléments du circuit de la figure 1 ;
la figure 4 représente une vue en coupe partielle de composants logiques modifiés selon la présente invention ; et
la figure 5 représente un schéma équivalent d'une structure comprenant des composants modifiés selon la présente invention.

Dans ces diverses figures, de mêmes éléments sont désignés par de mêmes références. Par ailleurs, dans les diverses vues en coupe de composants semiconducteurs, conformément à l'usage, les divers dimensions ne sont pas tracées à l'échelle mais arbitrairement dilatées pour faciliter la lisibilité des figures.

Le caisson logique 10 représenté en figure 1 comprend des transistors MOS dont la source est connectée à la masse. De plus, le caisson 10 est généralement connecté à la masse et l'on trouve donc des métallisations 30 reliant des régions de source 31 de type N à des régions 32 de type P surdopées servant de prise de contact avec le caisson 10, l'ensemble étant relié à la masse.

Comme le représente la figure 3, il existe donc, en parallèle sur le transistor de puissance TP, des transistors parasites t1 dont le collecteur correspond à la borne de drain du transistor de puissance TP, dont l'émetteur correspond à une région 31 de type N et dont la base correspond à une région 32 de type P. Comme dans tout transistor, il existe une résistance de base R_{BE} entre la base et l'émetteur. De même, comme dans tout transistor, il existe une capacité parasite C entre collecteur et base. Ainsi, quand la tension de drain VD monte rapidement, la capacité C peut être considérée comme un court-circuit et il passera un courant dans la résistance R_{BE} qui, quand il dépasse un certain seuil, met en conduction le transistor t1. Le transistor t1 étant de petite dimension, ce transistor est fort susceptible de se détruire quand il devient passant alors que la tension VD sur son collecteur est très élevée (proche de sa tension d'avalanche).

Pour résoudre ce problème, et tenter d'éviter le déclenchement des transistors t1, les inventeurs ont d'abord essayé de réduire autant que possible la résistance base-émetteur R_{BE} en optimisant le niveau de dopage des divers éléments et les formes des doigts d'émetteur-base des transistors considérés. Toutefois, cette solution n'a pas permis de résoudre le problème et on a continué à constater des claquages de structures monolithiques associant des transistors MOS de puissance verticaux et des circuits logiques réalisés dans un caisson logique, en cas de montée brutale de la tension sur la borne de drain (fort gradient de tension dV/dt).

Pour résoudre ce problème, la demanderesse propose de modifier dans le circuit logique tous les éléments dont une borne est reliée au potentiel du caisson et à la masse en rajoutant un élément résistif isolé entre la région sur laquelle on veut établir un contact et le contact proprement dit.

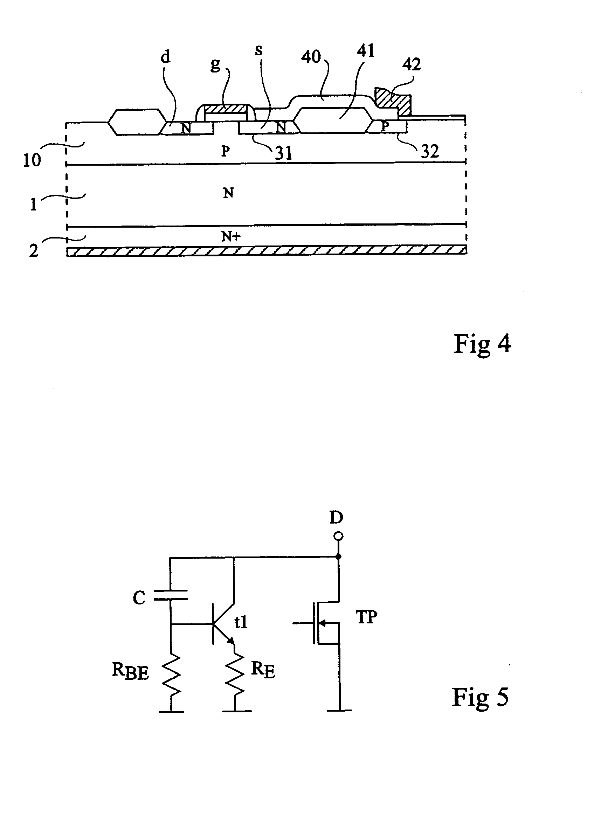

La figure 4 représente un exemple de réalisation de la présente invention. On a représenté dans cette figure un transistor MOS formé dans le caisson 10. Ce transistor comprend des régions de type N de drain et de source séparées par une zone du substrat surmontée d'une grille isolée g. La région de source est désignée par la référence 31 et une région de prise de contact avec le caisson est désignée par la référence 32. La connexion entre les régions 31 et 32 est réalisée par une portion de couche résistive 40, disposée par exemple au-dessus d'une région d'oxyde épais 41 séparant les régions 31 et 32. La couche 40 est par exemple en silicium polycristallin convenablement dopé pour présenter entre ses zones de contact avec les régions 31 et 32 une résistance suffisante, par exemple de l'ordre de 10 à 100 ohms. Ensuite, le contact avec la région 32 est réalisé de façon classique par exemple par une métallisation de contact 42. La métallisation 42 est disposée sur la couche 40 à un emplacement éloigné de la zone de contact avec la région 31 de façon à incorporer entre le contact 42 et la région 31 une résistance de valeur déterminée.

Le schéma équivalent de la structure modifiée selon la présente invention est illustré en figure 5. On voit que la couche 40 correspond à une résistance d'émetteur R_{E}.

Bien entendu, de très nombreuses variantes de réalisation de cette résistance d'émetteur R_{E} apparaîtront à l'homme de l'art. Il pourrait par exemple s'agir d'une couche de métallisation suffisamment longue pour être résistive. On pourra aussi former une couche de matériau résistif sur l'oxyde 41, une première métallisation reliant la surface de la région 31 à un premier côté du matériau résistif et une deuxième métallisation reliant la surface de la région 32 à un deuxième côté du matériau résistif.

De plus, à titre de variante, on pourra envisager que la deuxième borne de la résistance (celle qui n'est pas reliée à la source) est connectée non pas à la région 32 et à la masse mais à un noeud du circuit à basse impédance par rapport à la masse.

Ainsi, lorsqu'une montée rapide de tension apparaît sur la borne de drain D, comme précédemment, un courant circule dans la résistance R_{BE} à travers le condensateur C qui correspond alors sensiblement à un court-circuit. Toutefois, le seuil de déclenchement du transistor t1 devient plus élevé du fait de la présence de la résistance R_{E} et ensuite, même si ce transistor devient passant, le courant qui le traverse va être limité par la présence de cette résistance R_{E}. On évite ainsi de détruire le transistor t1 par passage d'un courant trop élevé dans celui-ci.

La valeur de la résistance R_{E} est choisie pour que, en fonctionnement normal, la chute de tension dans celle-ci soit négligeable, par exemple inférieure à 100 mV, pour ne pas dégrader les performances des circuits logiques.

## Revendications

1. Dispositif de protection contre des gradients de tension d'un composant monolithique comprenant un transistor MOS de puissance vertical et des circuits logiques, le composant ayant un substrat (1, 2) d'un premier type de conductivité correspondant au drain du transistor MOS, et les composants des circuits logiques étant réalisés dans au moins un caisson (10) du deuxième type de conductivité formé dans la face supérieure du substrat et comprenant au moins une région (31) du premier type de conductivité reliée à la masse des circuits logiques ou à un noeud à basse impédance par rapport à la masse, chacune desdites régions (31) étant en série avec une résistance (RE).

2. Dispositif selon la revendication 1, **caractérisé en ce que** la borne de chaque résistance (RE) non reliée à sa dite région (31) respective est reliée à un contact (32) sur le caisson (10), connecté à la masse.

3. Dispositif selon la revendication 1, **caractérisé en ce que** chaque résistance (RE) correspond à une région (40) de silicium polycristallin formée sur une couche d'oxyde (41).

4. Dispositif selon la revendication 3, **caractérisé en ce que** ladite couche d'oxyde (41) est une couche d'oxyde épais.

## Patentansprüche

1. Schutzvorrichtung gegen Spannungsgradienten für ein monolithisches Bauteil, welches einen vertikalen Leistungs-MOS-Transistor und logische Schaltungen umfaßt, wobei das Bauteil ein Substrat (1, 2) eines ersten Leitfähigkeitstyps entsprechend dem Drainbereich des MOS-Transistors aufweist und die Bauteile der logischen Schaltungen in wenigstens einem an der Oberseite des Substrats vorgesehenen Graben bzw. Kasten (10) vom zweiten Leitfähigkeitstyp ausgebildet sind und wenigstens einen Bereich (31) vom ersten Leitfähigkeitstyp aufweisen, der mit der Masse der logischen Schaltungen oder mit einem Knotenpunkt niedriger Impedanz gegenüber der Masse verbunden ist, und wobei jeder dieser Bereiche (31) in Reihe mit einem Widerstand (R_{E}) liegt

2. Vorrichtung nach Anspruch 1, **dadurch gekennzeichnet, dass** der nicht mit seinem entsprechenden Bereich (31) verbundene Anschluß jedes Widerstands (R_{E}) mit einem mit der Masse verbundenen Kontakt (32) auf dem Graben bzw Kasten (10) verbunden ist.

3. Vorrichtung nach Anspruch 1, **dadurch gekennzeichnet, dass** jeder Widerstand (R_{E}) jeweils einem auf einer Oxydschicht (41) ausgebildeten Bereich (40) aus polykristallinem Silizium entspricht

4. Vorrichtung nach Anspruch 3, **dadurch gekennzeichnet, dass** die genannte Oxydschicht (41) eine dicke Oxydschicht ist.

## Claims

1. A device for protection against voltage gradients of a monolithic component including a vertical MOS power transistor and logic circuits, said component having a substrate (1, 2) of a first type of conductivity corresponding to the drain of the MOS transistor, and the components of the logic circuits being realized in at least one well (10) of the second type of conductivity formed in the upper surface of the substrate, and comprising at least one region (31) of the first type of conductivity connected to the ground of the logic circuits, or to a node of low impedance with respect to the ground, each of said regions (31) being in series with a resistor (R_{E}).

2. The device of claim 1, wherein the terminal of each resistor (R_{E}) which is not connected to its respective region (31) is connected to a contact (32) on the well (10), connected to the ground.

3. The device of claim 1, wherein each resistor (R_{E}) corresponds to a polysilicon region (40) formed on an oxide layer (41).

4. The device of claim 3, wherein said oxide layer (41) is a thick oxide layer.
